Europäisches Patentamt

European Patent Office

Office européen des brevets

(11) Veröffentlichungsnummer: **0 177 725**
**B1**

(12) **EUROPÄISCHE PATENTSCHRIFT**

(45) Veröffentlichungstag der Patentschrift:
**23.11.88**

(21) Anmeldenummer: **85110528.8**

(22) Anmeldetag: **21.08.85**

(51) Int. Cl.⁴: **C 30 B 11/14,** C 30 B 33/00,
C 30 B 29/60

(54) **Verfahren zum Herstellen von grossflächigen Siliziumkristallkörpern für Solarzellen.**

(30) Priorität: **28.08.84 DE 3431592**

(43) Veröffentlichungstag der Anmeldung:
**16.04.86 Patentblatt 86/16**

(45) Bekanntmachung des Hinweises auf die Patenterteilung:
**23.11.88 Patentblatt 88/47**

(84) Benannte Vertragsstaaten:
**DE FR IT**

(56) Entgegenhaltungen:
**EP-A-0 095 707**
**DE-A-2 850 805**
**DE-A-3 017 914**
**DE-A-3 305 933**
**DE-A-3 338 335**

(73) Patentinhaber: **Siemens Aktiengesellschaft Berlin
und München, Wittelsbacherplatz 2, D-8000
München 2 (DE)**

(72) Erfinder: **Grabmaier, Christa, Dr. rer. nat., Am
Seefeld 17, D-8137 Berg (DE)**
Erfinder: **Kotschy, Josef, Dr. rer. nat.,
Kapellenstrasse 25, D-8025 Unterhaching (DE)**
Erfinder: **Lerchenberger, August, Dipl.- Ing. (FH),
Steinstrasse 28, D-8000 München 80 (DE)**

**Beschreibung**

Verfahren zum Herstellen von großflächigen Siliziumkristallkörpern für Solarzellen.

Die Erfindung betrifft ein Verfahren zum Herstellen von großflächigen Siliziumkristallkörpern für Solarzellen nach dem Fließbandprinzip, bei dem das in fester Form vorliegende Ausgangsmaterial auf einem während des Aufschmelzens und des nachfolgenden Kristallisierens von schmelzflüssigem Silizium nicht oder nur schlecht benetzbaren Trägerkörper in einer horizontalen Heizeranordnung zum Aufschmelzen und Kristallisieren gebracht wird und bei dem der Trägerkörper nach dem Kristallisieren wieder entfernt wird.

Aus der DE-OS-2 850 805 ist ein Verfahren zur Herstellung plattenförmiger Siliziumkristallkörper nach dem Fließbandprinzip bekannt, bei dem ein aus Graphit bestehender, in periodischen Abständen mit Löchern versehener Trägerkörper verwendet wird, der mit der Siliziumschmelze in Kontakt gebracht wird und das schmelzflüssige Silizium auf diesem Trägerkörper zum Kristallisieren gebracht wird. Vorzugsweise wird ein Graphitnetz mit angepaßter Maschenweite verwendet, welches nach der Kristallisation im gebildeten Siliziumkristallkörper integriert ist.

Ein weiteres kostengünstiges Verfahren zur Herstellung von plattenförmigen Siliziumkristallkörpern für Solarzellen ist aus der DE-OS-2 927 086 zu entnehmen. Dabei wird als Ausgangsmaterial Siliziumpulver verwendet, aus dem eine Folie hergestellt wird, die, auf ein Maß geschnitten, durch Sintern bei 1250 bis 1300°C zu freitragenden Siliziumplatten verarbeitet wird. Dabei wird in einer Weiterbildung nach der DE-OS-3 017 914 als Sinterunterlage Quarzgut oder Quarzsand, vorzugsweise als plattgepreßte Schüttung verwendet.

Die Aufgabe, die der Erfindung zugrundeliegt, besteht in der Herstellung freitragender Siliziumkristallkörper, bei der nicht nur nach dem Fließbandprinzip in kostengünstiger Weise gearbeitet werden kann, sondern auch gegenüber den bekannten Verfahren Prozeßschritte ohne Nachteile auf die Güte des Endproduktes vereinfacht und verbessert werden können.

Die erfindungsgemäße Aufgabe wird durch ein Verfahren der eingangs genannten Art dadurch gelöst, daß der Trägerkörper vor dem Aufbringen des die großflächigen Siliziumkristallkörper bildenden Siliziumausgangsmaterials mit einem, überwiegend aus Siliziumpulver mit einer Körnung kleiner 10 μm bestehenden Trennmittel versehen wird, welches nach dem Kristallisieren der Siliziumkristallkörper von diesen wieder entfernt wird, wobei als Ausgangsmaterial für die Siliziumkristallkörper Siliziumpulver mit einer Körnung zwischen 30 und 150 μm zu verwendet wird und die Wärmezufuhr für die Kristallisation in der Heizeranordnung überwiegend von oben erfolgt.

Gemäß einem Ausführungsbeispiel nach der Lehre der Erfindung wird zuerst das feine Siliziumpulver als dünne Schicht in einer Schichtdicke von kleiner 50 μm, vorzugsweise in einer Schichtdicke von 20 μm, und anschließend das die Siliziumkristallkörper bildende grobe Siliziumpulver in einer Schichtdicke im Bereich von 400 bis 600 μm, vorzugsweise 500 μm, auf den aus zum Beispiel Quarzglas oder Keramik bestehenden Platten aufgebracht. Die dünne Trennschicht verhindert ein Festkleben der kristallisierten Schicht aus grobem Siliziumpulver auf der Unterlage. Das feine Siliziumpulver lagert sich als poröse Siliziumschicht an die porenfrei kristallisierte, freitragende Siliziumkristallplatte an und ist nach dem Kristallisationsprozeß durch Abätzen in Kalilauge leicht entfernbar.

In einer Weiterbildung des Erfindungsgedankens ist vorgesehen, das als Ausgangsmaterial dienende Silizium in Form von Siliziumrohplatten oder -folien, hergestellt nach dem in der DE-OS-2 927 086 beschriebenen Verfahren, dem mit den Trennmittel versehenen Trägerkörper zuzuführen. Bei der Herstellung der Rohfolie oder -platte kann dabei auf den organischen Binder verzichtet werden, wenn das mit Wasser angeteigte Siliziumpulver gleich auf die aus Trennmittel bestehende Unterlage aufgebracht wird. Die Rohfolien werden aus grobem Siliziumpulver mit einer Körnung im Bereich von 30 bis 150 μm gezogen. Diese Körnung ist besonders gut geeignet, da mit diesen Folien oder Platten bei der Kristallisation porenfreie Siliziumkristallkörper mit Körnern größer 100 μm erhalten werden.

Die Temperaturbehandlung erfolgt in allen Fällen in einem Durchlaufofen mit unterschiedlichen Heizzonen zur Kristallisation, wobei die Wärmezufuhr überwiegend von oben erfolgt.

Wegen der Einfachheit der Verfahrensschritte und wegen der Tatsache, daß der Kristallisationsprozeß nicht von der Abführung der freiwerdenden Kristallisationswärme abhängig ist, läßt sich beim Verfahren nach der Lehre der Erfindung eine Flächengeschwindigkeit der herzustellenden Siliziumplatten von größer 1 $m^2$/min einstellen.

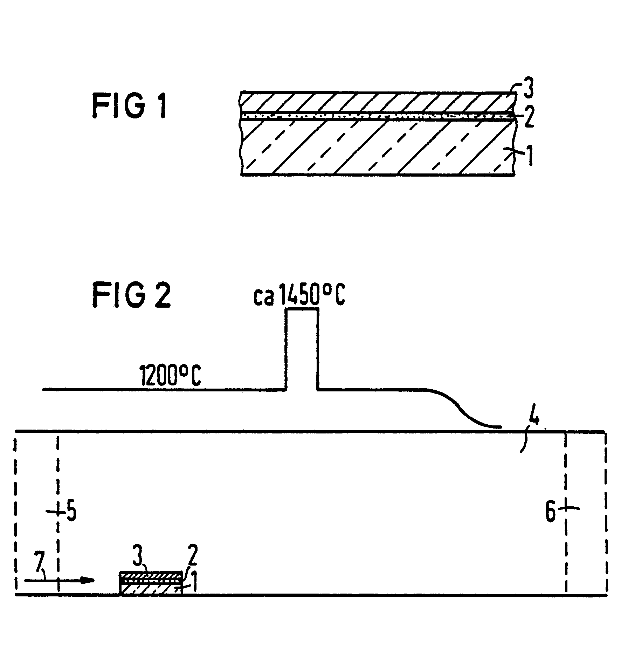

Im folgenden wird anhand eines Ausführungsbeispiels und der Figuren 1 und 2 das Verfahren nach der Lehre der Erfindung noch näher erläutert. Dabei zeigt

die Figur 1 im Schnittbild den mit der Trennschicht und den, den Siliziumkristallkörper bildenden Siliziumsausgangsmaterial versehenen Trägerkörper und

die Figur 2 in schematischer Darstellung das Temperaturprofil des horizontalen Heizofens.

In Figur 1 ist mit dem Bezugzeichen 1 der zum Beispiel aus keramischem Material bestehende Trägerkörper oder Support bezeichnet, mit 2 die ca. 20 μm dicke Trennschicht aus zum Beispiel feinpulvrigem Silizium und mit 3 das grobkörnige Siliziumpulver, aus dem der freitragende Siliziumkristallkörper gebildet wird. Die Schicht 3 kann auch aus Silizium in Folienform bestehen.

In Figur 2 ist mit dem Bezugszeichen 4 der Innenraum einer horizontalen Ofenanlage bezeichnet, an deren Enden Schleusen 5 und 6 angebracht sind. Der Pfeil 7 deutet die Bewegungsrichtung der Anordnung 1, 2, 3 an, welche durch einen Stoßmechanismus im Durchlaufbetrieb nach dem Fließbandprinzip (in der Figur nicht abgebildet) ausgelöst wird. Die Ofenanlage wird mit einer Grundlast von zum Beispiel 1200°C betrieben, die bis zur Ofenmitte aufrechterhalten wird. Wie dem Temperaturprofil zu entnehmen ist, wird die Temperatur in Ofenmitte auf 1430 - 1480°C ( = Kristallisationstemperatur) erhöht, bevor die Abkühlphase beginnt. Das grobkörnige Silizium 3, welches zum Beispiel als Rohfolie mit 50 % Dichte und einer mittleren Korngröße von 50 µm in einer Schichtdicke von 400 µm aufgebracht wird, schmilzt und füllt die Poren, so daß am Ende des Prozesses ein Siliziumkristallkörper von 200 µm Dicke mit einer Dichte von 100 % und einer Korngröße von größer 100 µm entsteht. Der geschwindigkeitsbestimmende Schritt ist der Transport von schmelzflüssigem Silizium zwischen die Körner. Dieser ist abhängig von der Korngröße, der Größe der Hohlräume, dem Fließverhalten und der Oberflächenspannung.

**Patentansprüche**

1. Verfahren zum Herstellen von großflächigen Siliziumkristallkörpern für Solarzellen nach dem Fließbandprinzip, bei dem das in fester Form vorliegende Ausgangsmaterial auf einem während des Aufschmelzens und des nachfolgenden Kristallisierens von schmelzflüssigem Silizium nicht oder nur schlecht benetzbaren Trägerkörper in einer horizontalen Heizeranordnung zum Aufschmelzen und Kristallisieren gebracht wird und bei dem der Trägerkörper nach dem Kristallisieren wieder entfernt wird, dadurch gekennzeichnet daß der Trägerkörper (1) vor dem Aufbringen des die großflächigen Siliziumkristallkörper bildenden Siliziumausgangsmaterials (3) mit einem, überwiegend aus Siliziumpulver mit einer Körnung kleiner 10 µm bestehenden Trennmittel (2) versehen wird, welches nach dem Kristallisieren der Siliziumkristallkörper (3) von diesen wieder entfernt wird, wobei als Ausgangsmaterial (3) für die Siliziumkristallkörper Siliziumpulver mit einer Körnung zwischen 30 und 150 µm verwendet wird, und die Wärmezufuhr für die Kristallisation in der Heizeranordnung (4) überwiegend von oben erfolgt.

2. Verfahren nach Anspruch 1, dadurch gekennzeichnet daß das Trennmittel (2) in einer Schichtdicke von kleiner 50 µm, vorzugsweise 20 µm, aufgebracht wird.

3. Verfahren nach Ansprüche 1 oder 2, dadurch gekennzeichnet daß das die Siliziumkristallkörper bildende Siliziumpulver (3) in einer Schichtdicke im Bereich von 400 bis 600 µm, vorzugsweise 500 µm, aufgebracht wird.

4. Verfahren nach einem der Ansprüche 1 bis 3, dadurch gekennzeichnet daß das Ausgangsmaterial (3) in Form einer ohne organischen Binder hergestellten Siliziumrohfolie dem Aufschmelzprozeß in der horizontalen Heizeranordnung (4) zugeführt wird.

5. Verfahren nach mindestens einem der Ansprüche 1 bis 4, dadurch gekennzeichnet daß als Trägerkörper (1) hitzebeständige Platten aus Quarzglas oder Keramik verwendet werden.

6. Verfahren nach mindestens einem der Ansprüche 1 bis 5, dadurch gekennzeichnet daß das an den kristallisierten Siliziumkristallkörpern (3) anhaftende Trennmittel (2) auf mechanischem Wege, vorzugsweise durch Abbürsten entfernt wird.

7. Verfahren nach mindestens einem der Ansprüche 1 bis 5, dadurch gekennzeichnet daß das an den kristallisierten Siliziumkristallkörpern (3) anhaftende Trennmittel (2) auf chemischem Wege durch Ätzen in vorzugsweise Kalilauge entfernt wird.

**Claims**

1. Process for the preparation of large-area silicon crystal bodies for solar cells according to the continuous strip principle, in which the starting material present in solid form, is carried during the melting down and subsequent crystallisation of molten silicon on a carrier body, which is not or only slightly wettable, in a horizontal heater arrangement for the melting down and crystallisation, and in which the carrier body is again removed after the crystallisation, characterised in that, prior to the application of the silicon starting material (3) for forming the large-area silicon crystal bodies, the carrier body (1) is provided with a parting agent (2) consisting preponderantly of silicon powder having a grain size less than 10 µm, which is removed from the carrier body again after the crystallisation of the silicon crystal bodies, where, as starting material (3) for the silicon crystal bodies, there is used silicon powder with a grain size between 30 and 150 µm, and the supply of heat for the crystallisation in the heater arrangement takes place preponderantly from above.

2. A process according to Claim 1, characterised in that the parting agent (2) is applied in a layer thickness of less than 50 µm, preferably 20 µm.

3. A process according to Claim 1 or 2, characterised in that the silicon powder (3) to form the silicon crystal bodies is applied in a layer thickness in the range of 400 to 600 µm, preferably 500 µm.

4. A process according to one of Claims 1 to 3, characterised in that the starting material (3) is supplied to the melting down process in the horizontal heater arrangement (4) in the form of a raw silicon film prepared without an organic binder.

5. A process according to at least one of Claims 1 to 4, characterised in that heat-resistant plates of quartz glass or ceramic are used as carrier bodies (1).

6. A process according to at least one of Claims 1 to 5, characterised in that the parting agent (2) adhering to the crystallised silicon crystal bodies (3) is removed mechanically, preferably by brushing off.

7. A process according to at least one of Claims 1 to 5, characterised in that the parting agent (2) adhering to the crystallised silicon bodies is removed chemically by etching, preferably in caustic potash solution.

**Revendications**

1. Procédé de fabrication à la chaîne de corps cristallins en silicium de grande surface pour des cellules solaires, qui consiste à mettre, dans un dispositif horizontal de chauffage, à fondre et à cristalliser le matériau de départ présent sous forme solide sur un corps-support non mouillable ou seulement peu mouillable pendant la fusion et la cristallisation ultérieures du silicium fondu, et à éliminer à nouveau le corps support, après la cristallisation, caractérisé en ce qu'il consiste à munir le corps support (1), avant le dépôt du matériau de départ en silicium (3) formant les corps cristallins en silicium de grande surface, d'un agent de séparation (2), constitué d'une manière prépondérante de poudre de silicum ayant une granulométrie inférieure à 10 microns, à l'éliminer du corps cristallin en silicium (3), après la cristallisation de celui-ci, en utilisant, comme matériau de départ (3) pour le corps cristallin en silicium, de la poudre de silicium ayant une granulométrie comprise entre 30 et 150 microns, et à effectuer l'apport de chaleur pour la cristallisation dans le dispositif de chauffage (4) principalement par le haut.

2. Procédé suivant la revendication 1, caractérisé en ce qu'il consiste à déposer l'agent de séparation (2) en une épaisseur de couche inférieure à 50 microns et, de préférence, de 20 microns.

3. Procédé suivant la revendication 1 ou 2, caractérisé en ce qu'il consiste à déposer la poudre de silicium (3) formant le corps cristallin en silicium en une épaisseur de couche de l'ordre de 400 à 600 microns et, de préférence, de 500 microns.

4. Procédé suivant l'une des revendications 1 à 3, caractérisé en ce qu'il consiste à amener le matériau de départ (3), sous la forme d'une feuille brute de silicium fabriquée sans liant organique, au processus de fusion dans le dispositif horizontal de chauffage (4).

5. Procédé suivant l'une au moins des revendications 1 à 4, caractérisé en ce qu'il consiste à utiliser comme corps support (1) des plaquettes en verre au quartz ou en céramique résistant à la chaleur.

6. Procédé suivant l'une au moins des revendications 1 à 3, caractérisé en ce qu'il consiste à éliminer l'agent de séparation (2) adhérant au corps cristallin en silicium (3) cristallisé, par des moyens mécaniques, de préférence par brossage.

7. Procédé suivant l'une au moins des revendications 1 à 5, caractérisé en ce qu'il consiste à éliminer l'agent de séparation adhérant au corps cristallin en silicium (3) cristallisé, par des moyens chimiques, notamment par attaque de préférence par de la lessive de potasse.

FIG 1

FIG 2

ca 1450°C

1200°C